Europäisches Patentamt

(19) European Patent Office

Office européen des brevets

(11) Numéro de publication : **0 057 126 B1**

(12) **FASCICULE DE BREVET EUROPÉEN**

(45) Date de publication du fascicule du brevet :
17.08.88

(21) Numéro de dépôt : **82400081.4**

(22) Date de dépôt : **18.01.82**

(51) Int. Cl.⁴ : **H 01 L 21/74, H 01 L 21/76**

(54) Procédé de fabrication d'une structure de transistors.

(30) Priorité : **27.01.81 FR 8101465**

(43) Date de publication de la demande :
**04.08.82 Bulletin 82/31**

(45) Mention de la délivrance du brevet :
**17.08.88 Bulletin 88/33**

(84) Etats contractants désignés :
**DE FR GB IT NL**

(56) Documents cités :
FR-A- 2 257 148
US-A- 4 044 452
PATENTS ABSTRACTS OF JAPAN, vol. 3, no. 18, 16
février 1979 page 123E91 & JP-A- 53 147482 (NIPPON
DENSHIN DENWA KOSHA) 22-12-1978
IBM TECHNICAL DISCLOSURE BULLETIN vol. 23,
no.1, juin 1980 NEW YORK (US) J.S. LECHATON et al.:
"Process for forming a deep substrate contact"
pages 171-172
IBM TECHNICAL DISCLOSURE BULLETIN vol. 23, no.
4, septembre 1983 NEW YORK (US) H.H. BERGER et
al.: "Method of producing transitors with optimum
base contact" pages 1487-1488
JOURNAL OF THE ELECTROCHEMICAL SOCIETY,
vol. 120, no. 11, novembre 1973 PRINCETON (US) R.V.
SCHWETTMANN et al.: " Etch rate characterization
of boron-implanted thermally grown SiO2" pages
1566-1577

(73) Titulaire : **THOMSON-CSF**
**173, Boulevard Haussmann**
**F-75379 Paris Cédex 08 (FR)**

(72) Inventeur : **Tonnel, Eugène**
**THOMSON-CSF SCPI 173, bld Haussmann**
**F-75360 Paris Cedex 08 (FR)**

(74) Mandataire : **Guérin, Michel et al**
**THOMSON-CSF SCPI 19, avenue de Messine**
**F-75008 Paris (FR)**

## Description

La présente invention concerne un procédé de fabrication d'une structure de transistors formée dans un caisson d'un circuit intégré dont le fond correspond à une couche enterrée. Elle sera décrite plus particulièrement en relation avec des transistors bipolaires mais s'applique également à d'autres types de transistors comme cela est exposé à la fin de la présente description.

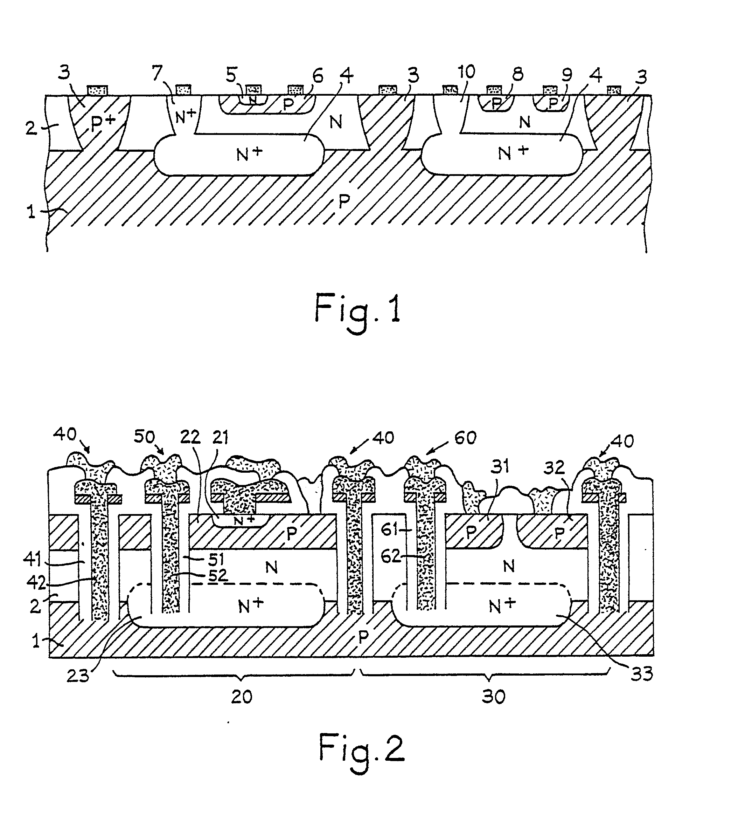

Diverses structures de transistors bipolaires dans des circuits intégrés sont bien connues et ne seront pas rappelées en détail ici. La figure 1 illustre à titre d'exemple deux structures particulières de l'art antérieur pour permettre de mieux faire ressortir les inconvénients que vise à éviter la présente invention. Le brevet US-A-4 029 527 en est un autre exemple.

De façon générale, un circuit intégré bipolaire est formé sur un substrat semiconducteur 1, couramment du silicium, d'un premier type de conductivité, par exemple de type P. Sur ce substrat est formée une couche épitaxiée de type N. Dans cette couche sont formés des caissons isolés par des murs d'isolement 3 de type P⁺ rejoignant le substrat 1 de type P. De façon classique, le fond de chacun des caissons comprend une couche 4 de type N⁺. Cette couche est couramment appelée couche enterrée du fait de sa disposition. Elle est habituellement formée à partir d'une implantation ionique réalisée dans le substrat avant la formation de la couche épitaxiée 2. Dans chacun des caissons, est ensuite formé le dispositif semiconducteur souhaité. Par exemple, en figure 1, le caisson de gauche contient un transistor NPN vertical comprenant une couche d'émetteur 5, une couche de base 6 et dont la couche enterrée correspond au collecteur. Le contact sur ce collecteur est repris par un puits de collecteur 7 de type N⁺. Le caisson de droite de la figure correspond à un transistor PNP latéral dans lequel l'émetteur correspond à une zone diffusée 8 et le collecteur à une zone diffusée 9. La couche enterrée 4 correspond en ce cas à une zone de reprise de base et le contact avec cette couche enterrée est assuré par un puits de base 10 de type N⁺ structurellement analogue au puits de collecteur 7 du transistor NPN vertical représenté dans le caisson de gauche. De façon générale, les diverses zones décrites précédemment sont réalisées par diffusion ou par implantation/diffusion.

L'un des objectifs couramment recherchés dans la fabrication des circuits intégrés est de réduire la dimension des circuits et de chacun des composants individuels de ces circuits. Si l'on examine la structure représentée en figure 1, de nombreuses difficultés se posent pour réaliser une telle réduction de dimension, notamment quand on cherche à réaliser des composants pouvant supporter des tensions élevées et laisser passer des courants relativement importants. En effet, pour ces transistors, d'une part l'augmentation du courant exige un accroissement de la surface dévolue au puits de collecteur donnant accès au collecteur enterré et d'autre part l'augmentation de l'épaisseur de la couche épitaxiale nécessaire à une tenue en tension élevée rend de plus en plus serrée la compétition qui s'exerce entre la descente des diffusions d'isolement et la remontée de la couche enterrée. D'autre part, comme le représente la figure, il est nécessaire de maintenir une distance de garde entre les couches descendantes correspondant aux murs d'isolement ou aux reprises de couches enterrées et les autres couches proches de type distinct. De façon plus explicite, et en se référant à la figure 1, il convient de laisser une distance de garde latérale entre les zones 3 et 7, les zones 7 et 6, les zones 6 et 3, les zones 3 et 10, les zones 10 et 8 et les zones 9 et 3. La prévision de cette distance minimale est nécessaire d'une part pour assurer une bonne tenue en tension, d'autre part pour réduire l'influence des transistors à effet de champ parasites qui pourraient être déclenchés par les passages de connexion au-dessus des couches considérées. En outre, comme on le voit dans la figure, du fait que les divers murs d'isolement et puits d'accès 3, 7, 10 sont obtenus par diffusion, leur largeur est nécessairement plus importante en surface qu'en profondeur et ce phénomène est de plus en plus accentué tandis que l'épaisseur de la couche épitaxiée 2 croît.

Diverses solutions ont été envisagées dans l'art antérieur pour résoudre ces inconvénients et notamment pour réduire la largeur en surface des couches diffusées descendantes destinées à former les murs d'isolement ou à contacter les couches enterrées. Ces solutions connues ne seront pas décrites en détail ici. On insistera néanmoins sur le fait qu'elles ne permettent généralement pas d'éviter le maintien d'une distance de garde entre des diffusions descendantes et des couches voisines et l'influence d'effets de champ parasites. Le brevet FR-A-2 257 148 montre un exemple d'une telle solution.

Ainsi, le but de la présente invention est de proposer un procédé de fabrication d'une nouvelle structure de transistor pour circuit intégré permettant de réduire les dimensions affectées aux murs d'isolement et aux puits de reprise de contact avec la couche enterrée et de supprimer la distance de garde évoquée précédemment tout en annulant l'influence des transistors à effet de champ parasites.

Ainsi la présente invention consiste en un procédé de fabrication d'un transistor formé dans un caisson d'un circuit intégré délimité latéralement par un sillon périphérique profond et dont le fond contient une couche enterrée dans un substrat semi-conducteur d'un premier type de conductivité, la couche enterrée étant d'un deuxième type de conductivité, comprenant les étapes consistant à :

a) former la couche enterrée localisée dans le substrat du premier type de conductivité au-dessus duquel est amené à croître une couche épitaxiée du deuxième type de conductivité ;

b) diffuser en des emplacements choisis de la couche épitaxiée des zones du premier type de conductivité pour former des couches fonctionnelles du transistor ;

c) creuser simultanément, d'une part, le sillon périphérique à section en U entourant complètement le transistor et la couche enterrée et pénétrant jusque dans le substrat au-dessous de la couche épitaxiée en dehors de la zone où la couche enterrée est présente et, d'autre part, une ouverture à section en U localisée au-dessus de la couche enterrée et pénétrant à l'intérieur de celle-ci sans la traverser complètement pour constituer un puits d'accès à la couche enterrée, ledit sillon et ladite ouverture coupant en certains emplacements les jonctions entre lesdites zones et la couche épitaxiée ;

d) procéder à une oxydation thermique pour isoler diélectriquement latéralement le sillon et l'ouverture avec une couche d'oxyde ;

e) procéder à une implantation ionique pour rendre le fond du sillon et de l'ouverture attaquable sélectivement ;

f) attaquer sélectivement la couche d'oxyde au fond du sillon et de l'ouverture pour l'éliminer ;

g) remplir le sillon et l'ouverture d'une substance conductrice permettant l'établissement d'un accès électrique vers le substrat par le sillon périphérique et d'un accès électrique vers la couche enterrée par l'ouverture,

h) achever la structure en réalisant les diffusions supplémentaires nécessaires et les interconnexions désirées.

Les sillons correspondant aux murs d'isolement et les sillons correspondant aux remontées de contact avec la couche enterrée sont réalisés simultanément par attaque chimique anisotrope.

Ces objets, caractéristiques et avantages ainsi que d'autres de la présente invention seront exposés plus en détail dans la description suivante de modes de réalisation particuliers faite en relation avec les figures jointes parmi lesquelles :

la figure 1 représente un exemple de structure bipolaire classique et a été décrite précédemment ;

la figure 2 représente un mode de réalisation d'une structure de transistor bipolaire obtenue avec un procédé selon la présente invention ;

les figures 3 à 7 représentent diverses étapes d'un procédé d'obtention d'une structure selon la présente invention telle qu'illustrée en figure 2 ;

la figure 8 représente une autre structure de transistor bipolaire obtenue avec un procédé selon la présente invention.

Dans ces diverses figures, conformément à l'usage dans le domaine de la représentation des semiconducteurs, les diverses dimensions des couches et structures ne seront pas représentées à l'échelle ni d'une figure à l'autre, ni à l'intérieur d'une même figure. D'autre part, dans ces figures de mêmes références désignent autant que faire se peut des éléments analogues.

En figure 2, comme en figure 1, on a représenté deux caissons d'une structure de circuit intégré, le premier caisson 20 contenant un transistor NPN vertical et le second caisson 30 contenant un transistor PNP latéral. On désignera à nouveau par les références 1 et 2 respectivement le substrat de type P et la couche épitaxiée de type N. Dans le caisson 20, un transistor NPN vertical comprend une couche d'émetteur 21 de type $N^+$, une couche de base 22 de type P et un collecteur comprenant une partie de la couche épitaxiée 2 de type N et la couche enterrée 23 de type $N^+$. Dans le caisson 30, un transistor PNP latéral comprend une couche d'émetteur 31 de type P et une couche de collecteur 32 de type P, ces couches étant séparées par une zone de base comprenant une portion de la couche épitaxiée 2 contenue dans le caisson considéré. Un contact avec cette zone de base est établi par une couche enterrée 33 de type $N^+$. Selon la présente invention, pour réaliser l'isolement sont prévus des sillons 40 isolés latéralement par une couche de silice ($SiO_2$) 41, ces sillons contenant une substance conductrice 42. Cette substance conductrice est en contact à la partie inférieure du sillon avec le substrat 1. On comprendra qu'il y a continuité entre les divers sillons 40 qui entourent complètement chacun des caissons et présentent un contour fermé. L'accès à la couche enterrée 23 est réalisé par un puits 50 isolé par une couche d'oxyde 51 et contenant une substance conductrice 52 assurant la remontée d'un contact avec la couche enterrée 23 de type $N^+$. De même, un puits 60 est isolé par une couche de silice 61 et contient une substance conductrice 62 assurant le contact avec la couche enterrée 33, c'est-à-dire avec la base du transistor PNP latéral contenu dans le caisson 30. Les sillons 40, 50 et 60 sont formés par attaque anisotrope, par exemple par attaque chimique en U dans du silicium choisi selon une orientation cristallographique (110) ou bien par des attaques directives par plasma.

Cette structure permet bien d'assurer les avantages annoncés précédemment dans la présente invention, à savoir que les sillons 40, 50 et 60 peuvent être plus étroits que les zones de diffusions descendantes 3, 7 et 10 du procédé classique de diffusion de l'art antérieur. D'autre part, le fait que les sillons soient isolés latéralement par une couche de silice permet de leur faire traverser des zones de jonction entre des couches P et N (dans l'exemple représenté entre les couches P 22, 31 et 32 et les zones de type N 2 correspondant à la couche épitaxiée). Il est donc inutile de prévoir les zones de garde nécessaires dans le cas de diffusions descendantes. Ceci permet de réduire les surfaces d'un caisson et de son mur d'isolement d'une valeur de l'ordre de 30 % dans le cas d'un transistor bipolaire et de l'ordre de 50 % lorsqu'il s'agit d'un transistor à effet de champ de type vertical double diffusé à grille silicium par exemple. D'autre part, il est possible de prévoir un matériau fortement conducteur 42, 52, 62 pour remplir les sillons ce qui permet d'en minimiser encore la surface.

Selon un autre avantage de la présente invention, qui sera décrit plus en détail ci-après en relation avec l'exposé du procédé de fabrication d'une structure telle que celle de la figure 2, on notera que les sillons d'accès aux couches enterrées et les sillons d'accès au substrat (murs d'isolement) sont réalisés simultanément, ce qui réduit le nombre des étapes de fabrication. Ceci résulte du fait que l'on peut avoir accès aux couches enterrées de type $N^+$ résultant d'une diffusion de zones implantées vers le haut et vers le bas à la même profondeur que celle à laquelle se présente le substrat en dehors des couches enterrées.

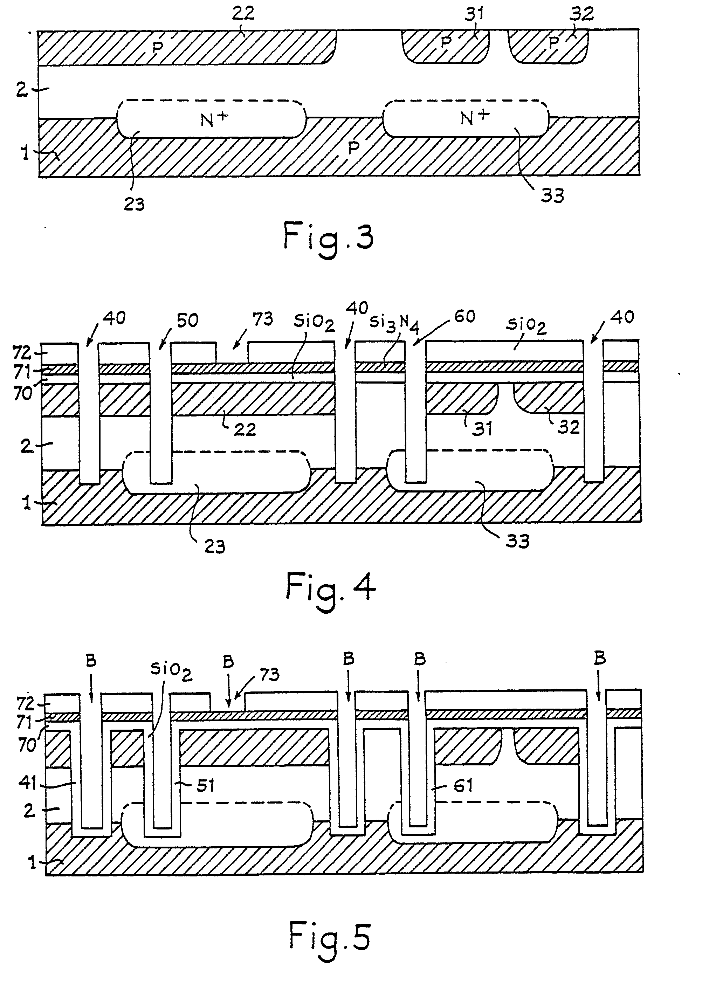

Les figures 3 à 7 représentent de façon schématique quelques étapes marquantes du procédé selon la présente invention.

Comme le représente la figure 3, on part d'un substrat 1 de silicium de type P et d'orientation (110), ce substrat étant surmonté d'une couche épitaxiée 2 de type N, et des couches enterrées localisées 23 et 33 étant formées dans des zones choisies de l'interface entre le substrat et la couche épitaxiée. Des diffusions de type P 22, 31 et 32 sont ensuite formées.

Ensuite, comme le représente la figure 4, on forme sur le substrat des couches successives 70, 71 et 72 de substances de masquage et de passivation attaquables sélectivement. Par exemple, la couche 70 est une couche de silice thermique, la couche 71 une couche de nitrure déposée en phase vapeur à basse pression et la couche 72 une couche de silice déposée également en phase vapeur à basse pression, cette dernière couche ayant une épaisseur suffisante pour assurer l'effet de masquage nécessaire vis-à-vis d'une implantation ionique qui sera exposée en relation avec la figure 5. On procède ensuite à l'ouverture de l'ensemble des trois couches 70, 71 et 72 aux endroits où l'on veut former les sillons 40, 50 et 60. On notera que lors de cette étape la couche de silice 72 est également ouverte en un emplacement 73 correspondant à la zone dans laquelle on veut former l'émetteur du transistor NPN vertical réalisé dans le caisson 20 (voir figure 2). Une attaque chimique anisotrope permet de creuser les sillons en leur maintenant une forme en U et une largeur peu supérieure à celle des ouvertures ménagées dans les couches de masquage 70, 71 et 72. Ainsi la largeur des sillons est définie par le masque et leur profondeur par la durée de l'attaque. L'attaque se poursuit vers le fond alors qu'elle est bloquée latéralement sur des plans (111) perpendiculaires au plan de la surface (110). En surface les sillons forment des parallélogrammes dont les angles sont voisins de 70° et de 110°. L'attaque est poursuivie jusqu'à ce que les sillons périphériques (ceux correspondant aux murs d'isolement) atteignent le substrat P. Les sillons internes (ceux qui débouchent dans les couches enterrées) atteignent alors la région enterrée. L'attaque du type anisotrope n'est pas sensible à la différence de type de conductivité du silicium. L'arrêt d'attaque doit être effectué dès que l'interface couche épitaxiée/substrat est franchie et avant que le fond des couches enterrées ne soit dépassé. Pour des circuits de puissance dans lesquels la couche épitaxiée a une épaisseur de l'ordre de 20 microns et la couche enterrée s'étend vers le haut jusqu'à une distance d'environ 15 microns de la surface et vers le bas jusqu'à une distance d'environ 30 microns de la surface, on dispose d'une latitude de l'ordre de la dizaine de microns pour arrêter l'attaque des sillons. Ceci est bien suffisant étant donné l'état actuel de la technologie. On a décrit ci-dessus un mode de réalisation utilisant une attaque chimique anisotrope sur un substrat d'orientation convenable mais on pourrait aussi utiliser d'autres techniques d'attaques directionnelles par exemple des attaques par plasma.

Comme l'illustre la figure 5, on procède alors à une étape d'oxydation thermique pour former les couches d'isolement latéral 41, 51 et 61. On notera bien entendu que cette oxydation thermique ne se développe pas sur le nitrure apparaissant en surface dans la zone 73 correspondant à la zone où l'on veut former la couche d'émetteur du transistor NPN vertical.

Lors de cette oxydation, le silicium donne naissance à un volume sensiblement double de silice. Ainsi, les parois latérales des sillons vont se rapprocher et les sillons auront tendance à se refermer. Afin de limiter cet effet, les sillons correspondant aux puits d'accès de la couche enterrée seront plus largement ouverts que les sillons correspondant aux murs d'isolement pour lesquels la recherche d'une faible résistance d'accès est moins importante. On pourra ainsi prévoir des ouvertures de 3 microns pour les sillons d'isolement et de 5 microns pour les puits d'accès à la couche enterrée ce qui laisse, après croissance d'une couche d'oxyde d'une épaisseur de l'ordre du micromètre, des largeurs respectives de 2 et 4 micromètres suffisantes pour permettre un remplissage ultérieur correct par une substance conductrice. Après cette oxydation, on procède à une implantation de bore orthogonalement à la surface de la plaquette. Cette implantation est désignée dans la figure par les flèches marquées B. Ainsi, le bore ou autre implant approprié pénètre dans la couche d'oxyde au fond des sillons et rend cette couche d'oxyde thermique sélectivement attaquable par rapport à la couche d'oxyde latérale. Plus exactement, la vitesse d'attaque pour certains produits connus devient plus grande dans les zone où du bore a été implanté que dans les zones où l'oxyde n'est pas dopé. Durant cette opération, la surface est également soumise au bombardement. Cependant, l'épaisseur de la couche de silice 70 et de la couche de nitrure 71 est suffisante pour arrêter les atomes de bore en dehors des fonds de sillons. On pourra se référer à l'article « Etch Rate Characterization of Boron — Implanted Thermally Grown $S_iO_2$ » de R.V. Schnettmann publié dans le « Journal of the Electrochemical Society », vol. 120, n° 11, novembre 1973, Princeton (US), pages 1566 à 1570.

On immerge alors la plaquette dans un produit d'attaque approprié de façon à éliminer la silice présente au fond des sillons de sorte que ces sillons débouchent sans isolement dans la couche semiconductrice sousjacente. Lors de cette étape ou à l'aide d'autres étapes d'attaque sélective on pourra également mettre à nu le silicium dans la zone 73 correspondant aux zones d'émetteur du transistor NPN.

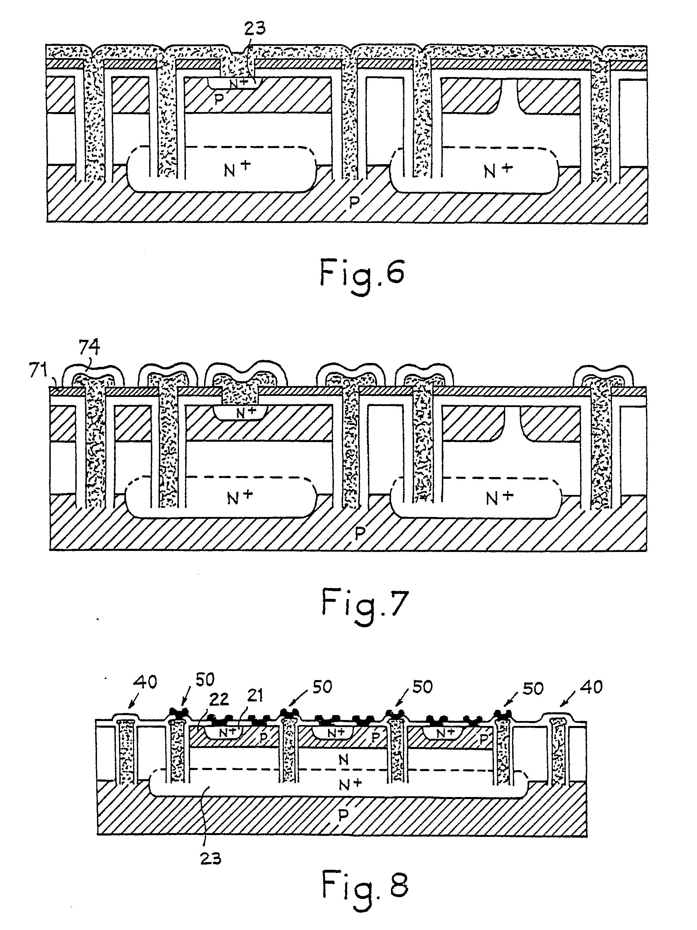

Lors des étapes ultérieures illustrées en figure 6, on dépose une substance conductrice de façon à combler les sillons. Cette substance conductrice peut par exemple être une couche de silicium polycristallin. Cette opération peut être effectuée par divers procédés connus ou bien pour obtenir une couche de silicium polycristallin uniforme ou bien en favorisant le dépôt uniquement dans les sillons. Dans ce dernier cas, l'ouverture des émetteurs n'aura pas été effectuée préalablement et le dépôt sera arrêté lorsque les sillons seront remplis.

Le silicium polycristallin déposé pourra être initialement dopé de type N⁺ de façon qu'il serve ensuite de source pour les émetteurs 23. Néanmoins, les émetteurs pourront être formés indépendamment. La gravure de l'éventuel silicium polycristallin excédentaire est effectuée en utilisant comme masque la couche d'oxyde formée durant la diffusion d'émetteur 23. Pendant cette opération, on définit les régions de contact émetteur/collecteur et les résistances d'équilibrage des transistors NPN (correspondant à la couche de silicium polycristallin déposée au-dessus de ces émetteurs) ainsi que l'électrode de base des transistors PNP latéraux.

Une structure dans laquelle le silicium polycristallin a été enlevé et maintenu en des emplacements choisis est illustrée en figure 7. La référence 74 désigne des couches d'oxyde développées à la surface des îlots de silicium polycristallin apparaissant en surface. Cette oxydation est masquée par la couche de nitrure 71 et permet d'isoler convenablement des parties des zones de silicium polycristallin dopées affleurant, pouvant servir de connexions isolées de la nappe de métallisation d'aluminium déposée ultérieurement et illustrée par des zones tiretées en figure 2. Cette couche d'oxyde permet l'élimination par attaque sélective de la couche de nitrure restante (voir figure 2). Le procédé peut se terminer comme cela est connu dans les techniques de fabrication classique des circuits intégrés de type MOS par le dépôt et le fluage d'une couche de silice d'isolement dopée et par l'ouverture de contacts.

Les contacts sont ouverts simultanément sur le silicium polycristallin pour les régions N⁺, les résistances et les zones de passage et sur le monocristal pour les régions P, de base du transistor NPN, d'émetteur/collecteur des transistors PNP latéraux ou de résistances, par exemple.

La gravure des interconnexions dans une couche d'aluminium permet de réaliser les connexions des éléments d'un circuit et les différentes cellules qui composent les transistors NPN ou les transistors PNP latéraux de puissance.

On a décrit de façon détaillée précédemment une structure dans laquelle les sillons sont remplis d'une couche de silicium polycristallin. On notera que si l'on veut réduire encore la résistance d'accès aux couches profondes, on pourra former un siliciure, par exemple un siliciure de platine PtSi, un siliciure de molybdène MoSi₂, un siliciure de tungstène WSi₂...

Bien entendu, la présente invention qui concerne essentiellement un mode d'accès simultané à une couche enterrée et au substrat dans une structure de transistor bipolaire ou d'autres structures semiconductrices analogues réalisées dans des caissons comprenant des couches enterrées localisées est susceptible de nombreuses variantes et pourra s'appliquer à de nombreux dispositifs.

Par exemple, la figure 8 représente un transistor NPN de puissance multicellulaire dans lequel sont prévus plusieurs émetteurs et plusieurs puits d'accès à la couche enterrée de collecteur. Cette figure ne sera pas décrite en détail étant donné que la structure de transistor multicellulaire représentée correspond sensiblement à une multiplication de la structure de transistor NPN illustrée dans le caisson 20 de la figure 2, cette structure de transistor étant isolée par un mur d'isolement unique 40. On a seulement inséré en figure 8 des références numériques analogues à celles de la figure 2 (caisson 20).

Comme exemple de structure non bipolaire selon la présente invention, on peut citer des transistors MOS de puissance à fonctionnement vertical qu'il peut être utile pour certaines applications de réaliser sur des plaquettes du type plaquettes de transistors bipolaires comportant une couche enterrée. La couche enterrée correspond alors au drain de la structure. On pourra envisager divers types de transistors MOS à fonctionnement vertical réalisables de cette manière et notamment des transistors de type DMOS à grille silicium.

**Revendications**

1. Procédé de fabrication d'un transistor formé dans un caisson d'un circuit intégré délimité latéralement par un sillon périphérique profond et dont le fond contient une couche enterrée dans un substrat semi-conducteur d'un premier type de conductivité, la couche enterrée étant d'un deuxième type de conductivité, comprenant les étapes consistant à :

   a) former la couche enterrée localisée (23, 33) dans le substrat (1) du premier type de conductivité au-dessus duquel est amené à croître une couche épitaxiée (2) du deuxième type de conductivité ;

   b) diffuser en des emplacements choisis de la couche épitaxiée des zones (22, 31, 32) du premier type de conductivité pour former des couches fonctionnelles du transistor ;

   c) creuser simultanément, d'une part, le sil-

lon (40) périphérique à section en U entourant complètement le transistor et la couche enterrée et pénétrant jusque dans le substrat au-dessous de la couche épitaxiée en dehors de la zone où la couche enterrée est présente et, d'autre part, une ouverture (50, 60) à section en U localisée au-dessus de la couche enterrée et pénétrant à l'intérieur de celle-ci sans la traverser complètement pour constituer un puits d'accès à la couche enterrée, ledit sillon et ladite ouverture coupant en certains emplacements les jonctions entre lesdites zones et la couche épitaxiée ;

d) procéder à une oxydation thermique pour isoler diélectriquement latéralement le sillon et l'ouverture avec une couche d'oxyde (41, 51, 61) ;

e) procéder à une implantation ionique pour rendre le fond du sillon et de l'ouverture attaquable sélectivement ;

f) attaquer sélectivement la couche d'oxyde au fond du sillon et de l'ouverture pour l'éliminer ;

g) remplir le sillon et l'ouverture d'une substance conductrice (42, 52, 62) permettant l'établissement d'un accès électrique vers le substrat par le sillon périphérique et d'un accès électrique vers la couche enterrée par l'ouverture,

h) achever la structure en réalisant les diffusions supplémentaires nécessaires et les interconnexions désirées.

2. Procédé selon la revendication 1, caractérisé en ce que le substrat semiconducteur (1) est en silicium et la substance conductrice remplissant les sillons en silicium polycristallin dopé.

3. Procédé selon la revendication 1, caractérisé en ce que le sillon (40) et l'ouverture (50, 60) résultent d'une attaque anisotrope dans du silicium d'orientation « 110 ».

4. Procédé selon la revendication 1, appliqué à la fabrication d'un transistor bipolaire NPN de puissance à fonctionnement vertical, dans lequel le substrat est un substrat (1) de silicium de type P, la couche épitaxiée une couche de type N (2), la couche enterrée une couche de type N⁺ (23), et dans lequel l'ensemble de la surface du caisson comprend une couche de type P de base (22) dans laquelle est formée une zone d'émetteur (21), de même que du silicium polycristallin est déposé au cours de la même étape dans le sillon (40) et l'ouverture (50) pour assurer le contact respectivement avec le substrat (1) et avec la couche enterrée (23).

**Claims**

1. A process for manufacturing a transistor realised in a caisson of an integrated circuit laterally delimited by a deep peripheral trench, the bottom of the caisson containing a layer embedded in a semiconductor substrate having a first type of conductivity, the embedded layer having a second type of conductivity, and the process comprising the following steps :

a) producing the localized embedded layer (23, 33) in the substrate (1) of the first conductivity type, at the upper side of which an epitaxial layer (2) of the second conductivity type is made to grow ;

b) diffusing zones (22, 31, 32) of the first conductivity type in selected locations of the epitaxial layer in order to constitute functional layers of the transistor ;

c) simultaneously digging, on the one hand, the peripheral trench (40) having an U-shaped section and completely surrounding the transistor and the embedded layer, this digging penetrating down into the substrate below the epitaxial layer outside the zone, in wich the embedded layer is present, and, on the other hand, an opening (50, 60) having an U-shaped section localized above the embedded layer and penetrating into the latter without traversing it entirely, in order to constitute an access to the embedded layer, said trench and said opening cutting the junctions between said zones and the epitaxial layer at certain locations ;

d) proceeding with a thermal oxidation for laterally insulating dielectrically the trench and the opening by means of an oxide layer (41, 51, 61) ;

e) proceeding with an ion implantation for rendering the bottom of the trench and of the opening selectively accessible to etching ;

f) selectively etching the oxide layer on the bottom of the trench and of the opening in view of its elimination ;

g) filling the trench and the opening with a conductive substance (42, 52, 62) permitting the realisation of an electrical access to the substrate via the peripheral trench, and an electrical access to the embedded layer via the opening ;

h) finalizing the structure by realising the necessary supplementary diffusions and the desired interconnections.

2. A process according to claim 1, characterized in that the semiconductor substrate (1) is made of silicon and the conductive substance filling the trenches is made of doped polycristalline silicon.

3. A process according to claim 1, characterized in that the trench (40) and the opening (50, 60) are obtained by an anisotropic etching treatment in a (110) orientation type of silicon.

4. A process according to claim 1, applied to the manufacture of a vertical, bi-polar NPN power transistor, in which the substrate is a P type silicon substrate (1), the epitaxial layer is N type layer (2), the embedded layer is a N⁺ type layer (23), and in which the entire surface of the caisson comprises a P type basis layer (22), in which an emitter zone (21) is formed, and that polycristalline silicon is deposited during the same step of manufacture in the trench (40) and in the opening (50) in order to ensure the respective contacts with the substrate (1) and the embedded layer (23).

**Patentansprüche**

1. Verfahren zur Herstellung eines Transistors in der Wanne eines integrierten Schaltkreises, die seitlich durch einen tiefen Umfangsgraben begrenzt ist und deren Boden eine Schicht enthält, die im Halbleitersubstrat eines ersten Leitfähigkeitstyps eingebettet ist, wobei die eingebettete Schicht von einem zweiten Leitfähigkeitstyp ist, und das Verfahren folgende Stufen umfaßt :

a) Die lokalisierte eingebettete Schicht (23, 33) wird im Substrat (1) des ersten Leitfähigkeitstyps ausgebildet, über der eine Epitaxieschicht (2) des zweiten Leitfähigkeitstyps zum Wachsen gebracht wird ;

b) Zonen (22, 31, 32) des ersten Leitfähigkeitstyps werden an ausgewählten Stellen der Epitaxieschicht zur Bildung von Funktionsschichten des Transistors eindiffundiert ;

c) gleichzeitig wird einerseits der Umfangsgraben (40) mit Uförmigem Querschnitt, welcher den Transistor und die eingebettete Schicht vollständig umschließt und bis in das Substrat unter der Epitaxieschicht außerhalb der Zone, wo sich die eingebettete Schicht befindet, eindringt und andererseits eine Öffnung (50, 60) mit U-förmigem Querschnitt ausgebildet, die oberhalb der eingebetteten Schicht liegt und die bis in das Innere derselben eindringt, ohne sie vollständig zu durchqueren und die einen Zugangsschacht zur eingebetteten Schicht bildet, wobei der Graben und die Öffnung an bestimmten Stellen die Übergänge zwischen den genannten Zonen und der Epitaxieschicht durchtrennen ;

d) es wird eine thermische Oxidation zur dielektrischen seitlichen Isolierung des Grabens und der Öffnung mithilfe einer Oxidschicht (41, 51, 61) durchgeführt ;

e) man führt eine Ionenimplantation durch, um den Boden des Grabens und der Öffnung selektiv ätzbar zu machen ;

f) die Oxidschicht am Boden des Grabens und der Öffnung wird durch Ätzen beseitigt ;

g) der Graben und die Öffnung werden mit einer leitenden Substanz (42, 52, 62) gefüllt, um einen elektrischen Zugang zum Substrat durch die Umfangsrille und zur eingebetteten Schicht durch die Öffnung zu gewinnen ;

h) die Struktur wird durch Ausführen zusätzlicher notwendiger Diffusionen und der gewünschten Schaltverbindungen vervollständigt.

2. Verfahren nach Anspruch 1, dadurch gekennzeichnet, daß das Halbleitersubstrat (1) aus Silicium und die die Gräben ausfüllende leitende Substanz aus dotiertem, polykristallinem Silicium besteht.

3. Verfahren nach Anspruch 1, dadurch gekennzeichnet, daß der Graben (40) und die Öffnung (50, 60) durch anisotropes Ätzen in Silicium mit der Orientierung (110) gebildet werden.

4. Verfahren nach Anspruch 1, angewendet auf die Herstellung eines vertikalen bipolaren NPN-Leistungstransistors, bei dem das Substrat ein Silicium-Substrat (1) vom Typ P, die Epitaxieschicht eine Schicht (2) vom Typ N, die eingebettete Schicht eine Schicht (23) vom Typ N⁺ ist, und bei dem die gesamte Oberfläche der Wanne eine Basisschicht (22) vom Typ P ist, in welcher eine Emitterzone (21) gebildet wird, wie auch, daß polykristallines Silicium während der gleichen Verfahrensstufe im Graben (40) und in der Öffnung (50) aufgebracht wird, um den jeweiligen Kontakt mit dem Substrat (1) und der eingebetteten Schicht (23) herzustellen.

Fig.1

Fig.2

Fig.3

Fig.4

Fig.5

Fig.6

Fig.7

Fig. 8